# EUROPEAN PATENT SPECIFICATION

(11) **EP 2 319 952 B1**
(45) Date of publication and mention of the grant of the patent: **03.12.2014**
(21) Application number: 10188681.0
(22) Date of filing: 25.10.2010
(51) Int. Cl.: C23C 14/24, C23C 14/22, C23C 14/26

(54) **Method and system for depositing multiple materials on a substrate**
Verfahren und System zur Ablagerung mehrere Materialien auf einem Substrat
Procédé et système pour déposer plusieurs matériaux sur un substrat

(30) Priority: 29.10.2009 US 608455
(43) Date of publication of application: 11.05.2011
(73) Proprietor: First Solar Malaysia SDN.BHD, Aman (MY)
(72) Inventor: Korevaar, Bastiaan Arie, Niskayuna, NY 12309 (US); Ahmad, Faisal Razi, Niskayuna, NY 12309 (US); Deluca, John Anthony, Niskayuna, NY 12309 (US); Johnson, James Neil, Niskayna, NY 12309 (US); Lemmon, John Patrick, Kennewick, WA 99338 (US); Xi, Yangang Andrew, Niskayuna, NY 12309 (US)
(74) Representative: Thompson, Andrew John

(56) References cited:
- US-A- 4 281 029
- US-A1- 2004 040 504
- US-A1- 2005 175 770
- US-A1- 2009 173 279

## Description

This invention relates generally to methods and systems for depositing multiple materials on a substrate. More particularly, this invention relates to methods and systems for deposition of multiple materials on a substrate using co-sublimation processes for solar or photovoltaic cells.

Photovoltaic systems (or "solar cells") are used for converting solar energy into electrical energy. Power production by photovoltaic systems may offer a number of advantages over conventional systems, including low operating costs, high reliability, modularity, low construction costs, and environmental benefits.

The thin film solar cells have the potential to lower costs since such cells require significantly smaller amounts of semiconductor materials relative to conventional photovoltaic modules to produce a comparable amount of power. Currently, some thin film solar cells employ cadmium telluride (CdTe) films because CdTe has a direct bandgap of 1.5eV and can improve solar conversion efficiency of such solar cells.

In some applications, in order to improve various properties of the solar cells, such as the electrical conductivity of CdTe films, dopants may be introduced in the CdTe films. However, conventional processes, such as conventional close spaced sublimation (CSS) and vapor transport (VTM) processes are not suited to codepositing CdTe with other materials, due to the different melting points and vapor pressures of the materials. One process that has been shown to co-deposit CdTe with other materials is co-evaporation. However, co-evaporation processes are inherently time-consuming and may not be suitable for co-deposition of CdTe and certain other materials for photovoltaic applications.

US 4,281,029 discusses a method of coating with a stoichiometric compound.

US 2004/040504 discloses an evaporation apparatus for film formation.

US 2009/173279 relates to a vacuum vapor deposition apparatus.

US 2005/175770 discusses fabricating an electrode for use in organic electronic devices.

Therefore, there is a need for a new and improved method and system for co-deposition of multiple materials on a substrate for solar or photovoltaic cells.

Various aspects and embodiments of the present invention are defined by the appended claims.

Various aspects, features, and advantages of the present disclosure will become more apparent in light of the subsequent detailed description when taken in conjunction with the accompanying drawings in which:
FIG. 1 is a schematic diagram of a deposition system in accordance with one embodiment of the invention;
FIG. 2 is a schematic diagram of a top view of a susceptor of the deposition system shown in FIG. 1 in accordance with one embodiment of the invention;
FIG. 3 is a schematic diagram of the top view of the susceptor of the deposition system shown in FIG. 1 in accordance with another embodiment of the invention;
FIG. 4 is a top view of a recess on the susceptor of the deposition system shown in
FIG. 1;

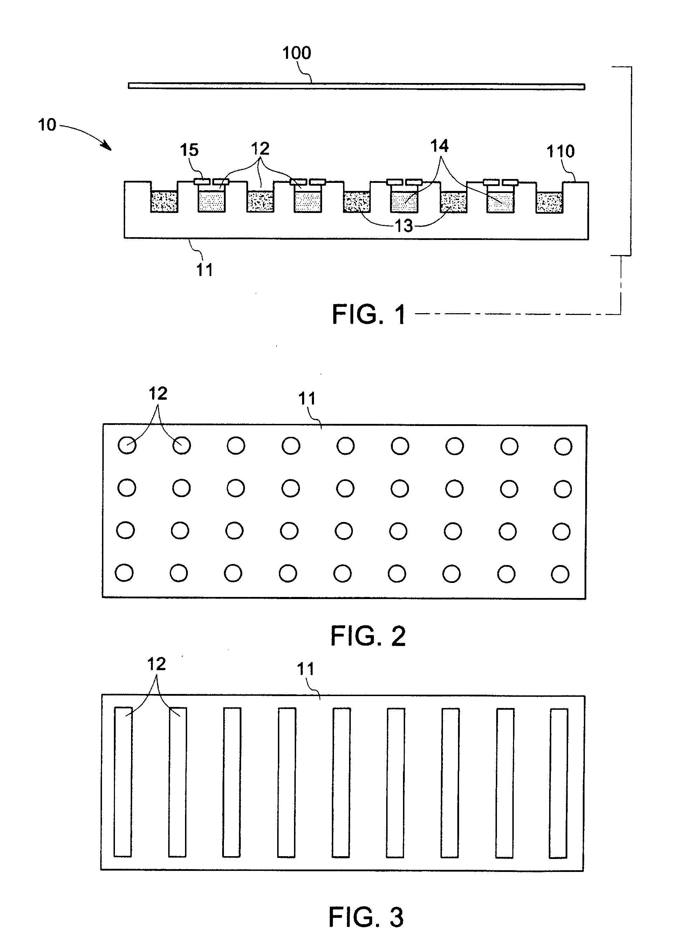

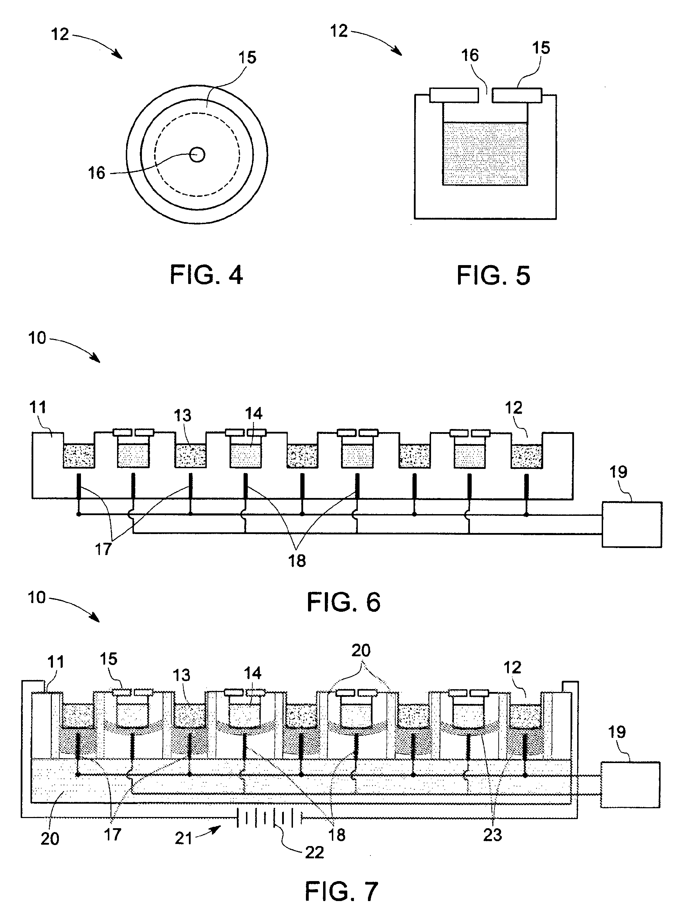

FIG. 5 is a cross sectional view of the recess on the susceptor of the deposition system shown in FIG. 1;
FIG. 6 is a schematic diagram of the deposition system equipped with multiple thermocouples;
FIG. 7 is a schematic diagram of the deposition system employing multiple thermal insulation layers;

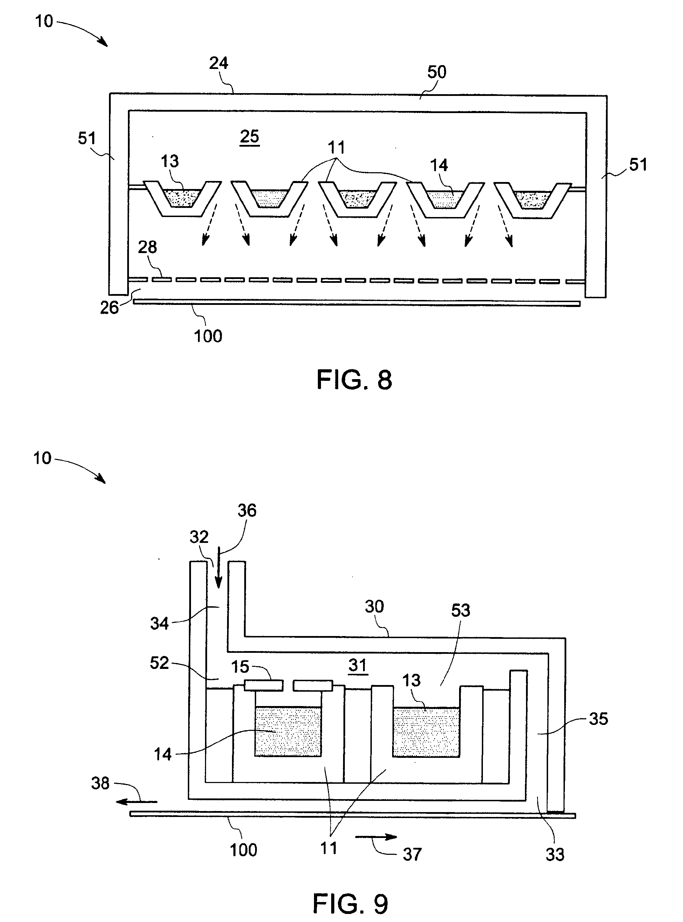

FIG. 8 is a schematic diagram of the deposition system with multiple spatially separated susceptors;
FIG. 9 is a schematic diagram illustrating another configuration of the deposition system;

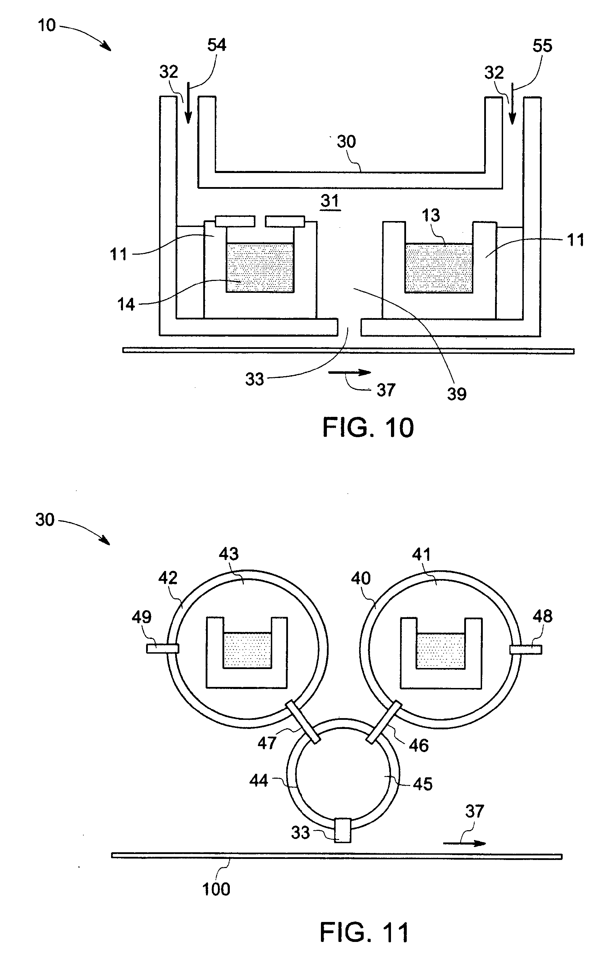

FIG. 10 is a schematic diagram illustrating yet another configuration of the deposition system; and
FIG. 11 is a schematic diagram illustrating another configuration of the deposition system.

Various embodiments of the present disclosure are described herein with reference to the accompanying drawings. In the subsequent description, well-known functions or constructions are not described in detail to avoid obscuring the disclosure in unnecessary detail.

FIG. 1 illustrates a schematic diagram of a deposition system 10 configured to deposit two or more different materials on a substrate 100. In some applications, the materials may be deposited on the substrate 100 for formation of solar or photovoltaic cells. Alternatively, the deposition system 10 may be used for manufacturing other devices.

A variety of substrates 100 may be employed, depending on the specific applications. In one non-limiting example, the substrate 100 comprises a glass layer (not shown) with a transparent conducting oxide (TCO) layer deposited on the glass layer. Non-limiting examples of the glass layer include borosilicate glass, low-alkaline glass, soda-lime glass, low-iron galss, and similar materials. Non-limiting examples of the TCO layer include tin oxide and indium tin oxide.

In other non-limiting examples, the substrate 100 may comprise a polymer layer with a metal layer deposited on the polymer layer. In one example, the polymer layer may comprise polyimide and the metal layer may comprise molybdenum. Additionally, in certain applications, the substrate 100 may comprise other suitable materials, for example, a stainless steel layer with a molybdenum layer deposited on the stainless steel layer.

For the example illustrated in FIG. 1, the system 10 comprises a susceptor 11 defining a plurality of recesses 12. The recesses 12 extend down from an upper surface 110 of the susceptor 11 and are spatially separated from each other for accommodating a first material 13 and a second material 14. The first and second materials 13, 14 are disposed alternately on the susceptor 11.

In some applications, the susceptor 11 may be formed of thermally conductive materials. Non-limiting examples of the thermal conductive materials include graphite, tungsten, silicon carbide (SiC) coated graphite, and high temperature metals and alloys, such as stainless steel and alloy steel. The first and second materials 13, 14 may comprise cadmium telluride (CdTe), tellurium (Te), zinc tellurium (ZnTe), arsenic (As), cadmium chloride (CdCl₂), cadmium sulfide (CdS), other materials containing dopants to CdTe, and combinations thereof. Non-limiting examples of the dopants may include silver (Ag), copper (Cu), gold (Au), bismuth (Bi), antimony (Sb), arsenic (As), phosphor (P), and nitrogen (N). In one example, the first material 13 comprises cadmium telluride (CdTe) and is different from the second material 14.

It should be noted that the arrangements illustrated in FIGS. 1-11 are merely illustrative. The same numerals in FIGS. 1-11 may indicate similar elements. In some examples, more than one susceptor 11 may be employed and/or more than two materials may be accommodated into the respective recesses 12 for deposition on the substrate 100.

For some arrangements, each of the recesses 12 may be in the form of cell, so that, as illustrated in FIG. 2, a plurality of spatially separated cells 12 may be arranged as a matrix on the susceptor 11 so as to form two or more cell columns. In some examples, each cell may have a rectangular or a cylindrical shape, and the cells in the same column may be used to receive the same material.

Alternatively, each of the recesses 12 may be in the form of trench, so that, as illustrated in FIG. 3, a plurality of trenches 12 may be distributed on the susceptor 11 to accommodate the respective first and second materials, which may be disposed alternately. In some examples, each trench may have a rectangular or an arc shaped cross-section.

The system 10 further comprises one or more heaters, such as a resistive heater 21 shown in FIG. 5 for heating the susceptor 11. In certain examples, other suitable heaters may be employed, including, without limitation, halogen lamps and radio frequency heaters, which may be easily implemented by one skilled in the art.

In operation, the one or more heaters heat the susceptor 11, so that the first and second materials 13, 14 in the respective recesses 12 are heated to a certain temperature to sublimate simultaneously. Then, the two sublimated gases mix together during transmission towards the substrate 100 so as to deposit on the substrate 100 in the form of film, which is referred to as a co-sublimation process.

In some examples, the first and second materials 13, 14 in the recesses 12 may be heated to the same temperature. In other examples, the first material 13 and the second material 14 may be heated to different temperatures.

Additionally, in some applications, in operation, the substrate 100 may be stationary relative to the susceptor(s) 11. Alternatively, the substrate 100 may move relative to the susceptor(s) 11. The substrate 100 may be preheated to a lower temperature than the respective heated temperatures of the first and second materials 13, 14.

Various techniques may be used to heat the first and second materials to different temperatures. For example, the geometry may differ for the respective recesses 12 for receiving the two materials. Thus, when one or more heaters are disposed below the susceptor 11 for heating the recesses 12, the recesses 12 having larger depths receive more thermal energy than the recesses with shallower depths, due to the thermal gradient. In this manner, the first and second materials are heated to different temperatures.

In other examples, the thermal conductivity for a subset of the recesses may be enhanced relative to that of the other recesses. For example, the system 10 may employ one or more materials disposed on periphery of and/or into the respective recesses 12 so as to react to, for example absorb more thermal energy from the one or more heaters. For example, one or more heat absorbing materials, such as titanium, may be disposed around the recesses 12 accommodating the first material 13, so that the first material 13 is heated to a higher temperature than the second material 14 for sublimation.

In the illustrated embodiment, the system 10 further employs a plurality of lids 15 disposed on respective ones of the recesses 12 for accommodating the second material 14. Each lid 15 defines an opening 16 that is in fluid communication with the recess 12.

FIGS. 4 and 5 illustrate a top view and a cross sectional view of one recess with one lid disposed thereon. As illustrated in FIGS. 4 and 5, the recess 12 has a cylindrical shape and the opening 16 is in fluid communication with the recess 12, so that, during the sublimation process, the dimension of the opening 16 may be adjusted via moving the lid 15 so as to adjust the sublimated vapor pressure of the second material 14. In some examples, the lids 15 may or may not be disposed on the first material recesses 12.

In some applications, the system 10 may employ one or more thermal monitoring devices to monitor the temperatures of the recesses 12. As depicted in FIG. 6, a plurality of first and second thermocouples 17 and 18 extend into the susceptor 11 and are disposed below the recesses 12 to detect the temperatures thereon so as to monitor the temperatures of the first and second materials 13, 14.

As depicted above, in some examples, the recesses 12 for accommodating the first and second materials may be heated to the same temperature. For many applications, however, the recesses 12 accommodating the first material and/or the second material are heated to different temperatures.

In certain applications, the first and second thermocouples 17 and 18 may be connected to a monitoring device 19 to monitor the temperature of each recess 12. In other examples, two or more monitoring devices may be used. Additionally, in some examples, the monitoring device(s) may be operatively connected to heater(s) to provide feedback for thermal control.

For certain arrangements, in order to independently control the temperature of each recess 12 and avoid interference from adjacent recesses 12, thermal insulation may be disposed on the susceptor 11. For example, one or more thermal insulation layers may be provided to better thermally isolate respective ones of the recesses from neighboring recesses.

FIG. 7 is a schematic diagram of the system 10 employing a plurality of thermal insulation layers 20. As illustrated in FIG. 7, the system 10 comprises a plurality of recesses 12 defined on a susceptor 11 for accommodating the first and second materials 13, 14. The thermal insulation layers 20 are disposed at two ends of the susceptor 11 and between every two adjacent recesses 12 for thermal insulation.

Non-limiting examples of the thermal insulation include polystyrene, polyurethane, polystyrene foam, and ceramic materials. For the illustrated arrangement, the thermal insulation layer 20 is further disposed on a bottom surface (not labeled) of the susceptor 11 to reduce thermal convection via the bottom surface of the susceptor 11. In other examples, thermal insulation is not employed on the bottom surface of the susceptor 11.

In the illustrated example of FIG. 7, the system 10 further comprises a plurality of lids 15 disposed on the recesses 12 for accommodating the second material 14 and a resistive heater 21 for heating the respective recesses 12. In some examples, one or more lids 15 may or may not be disposed on the one or more recesses 12 for accommodating the first material 13. The resistive heater 21 comprises a coil 23. In the illustrated example, the coil 23 is disposed around each of the recesses 12. The system 10 further comprises a power source 22 provided for the coil 23 and configured to pass an electrical current through the coil 23 to heat the recesses 12.

In the illustrated example, the coil 23 has more turns on the recesses 12 receiving the first material 13 than those on the recesses 12 receiving the second material 14. In this manner, the first material 13 and the second material 14 are heated separately and the first material 13 may be heated to a higher temperature than the second material 14.

Additionally, the example system 10 shown in FIG. 7 also employs a plurality of first and second thermocouples 17 and 18 configured to monitor the temperatures of the first and second materials 13, 14 respectively. In some examples, one or more monitoring devices 19 may also be operatively connected to the first and second thermocouples 17 and 18, and may further be operatively connected to the heater 21 to provide feedback for thermal control.

FIG. 8 is a schematic diagram of the system 10 having a plurality of spatially separated susceptors. As illustrated in FIG. 8, the system 10 comprises a plurality of spatially separated susceptors 11 for accommodating the first and second materials, and a deposition device 24 defining a sublimation zone 25 with a lower opening 26. The spatially separated susceptors 11 are disposed within the sublimation zone 25. A substrate 100 is disposed below the deposition device 24.

Similarly, the system 10 may comprise one or more heaters for heating the susceptors 11.In some examples, the heater(s) may be disposed outside the deposition device 24. In other examples, the heater(s) may be disposed within the sublimation zone 25, and/or within an upper wall 50 and/or sidewalls 51 of the deposition device 23 for heating the susceptors 11.

In operation, the first and second materials 13, 14 sublime at a certain temperature. Since the temperature of the deposition device 24 is higher than the temperatures to which the first and second materials 13, 14 are heated, the sublimated gases of the first and second materials 13, 14 are not deposited on the inner surfaces of the deposition device 24 and are transmitted in a downward direction for deposition on the substrate 100, as indicated by the dashed arrows.

In the illustrated example of FIG. 8, the system 10 further comprises a diffusion element 28 for diffusion and thus more uniform distribution of the sublimated gases on the substrate 100. In certain applications, more than one diffusion element 28 may be employed. Similarly, during deposition, the temperature of the diffusion element(s) 28 may also be higher than the temperatures to which the first and second materials are heated, so that the sublimated gases are deposited on the substrate 100 and not on diffusion element(s) 28.

For the illustrated arrangement, the substrate 100 is disposed below the deposition device 24. More than two spatially separated susceptors 11 are employed and each susceptor 11 defines a recess 12. In other examples, the substrate 100 may also be disposed within the sublimation zone 25 and between the upper wall 50 and the susceptors 11. The system 10 may employ two susceptors, and each susceptor 11 may define more than one recess 12.

Additionally, for the arrangements in FIGS. 1-7, the system 10 may also employ a deposition device to accommodate the susceptor(s) 11, which may be similar to the deposition device 24 shown in FIG. 8, but may define an upper opening, so that the substrate 100 is disposed above the susceptor(s) 11 for deposition. One or more diffusion elements similar to the diffusion element 28 shown in FIG. 8 may also be disposed between the substrate 100 and the susceptor(s) 11.

The above-described sublimation and deposition processes may be performed in a variety of environments, for example, in an ambient environment or in the presence of a gas, such as oxygen, hydrogen, nitrogen, chlorine, an inert gas, and combinations thereof. Non-limiting examples of inert gases include argon and helium.

FIG. 9 is a schematic diagram of another configuration of the system 10. As illustrated in FIG. 9, the system 10 comprises a deposition device 30 defining a sublimation zone 31 and two susceptors 11 both disposed within first and second sublimation zones 52, 53 of the sublimation zone 31. The sublimation device 30 further defines an inlet 32, an inlet passage 34, an outlet 33, and an outlet passage 35 in fluid communication with the sublimation zone 31. A substrate 100 faces the outlet 33.

For the illustrated example of FIG. 9, the system 10 further comprises a carrier gas source (not shown) and one or more heaters (not shown). The carrier gas source is configured to supply a carrier gas into the sublimation zone 31 through the inlet 32 and the inlet passage 34. The one or more heaters are configured to heat and sublimate the first and second materials 13, 14, and may be disposed outside of the sublimation device 30, around the susceptors 11 and/or within one or more walls (not labeled) defining the sublimation zone 31.

In operation, the one or more heaters heat the susceptors 11 to sublimate the first and second materials 13, 14. The first and second materials are heated to different temperatures for sublimation. The carrier gas source supplies a carrier gas 36 into the sublimation zone 31 to carry the sublimated gases out of the sublimation zone 31 through the outlet passage 35 and the outlet 32. Subsequently, the first and the second materials are continuously deposited on the substrate 100 while the substrate 100 moves along a direction 37, which is opposite to the direction 38 of the depleted carrier gas.

In the illustrated example, while moving toward the outlet 33, the sublimated gases are mixed in the outlet passage 35, which thus acts as a mixing zone, and thereby improves the quality of the deposition on the substrate 100. In some applications, the outlet passage 35 may not be employed. The carrier gas 36 may be saturated with the sublimated gases of the first and second materials 13, 14 to facilitate deposition on the substrate 100. The substrate 100 may move in the same direction as the depleted carrier gas or may be stationary.

Additionally, the temperatures of the sublimation device 30 and the substrate 100 may be higher and lower than the heated temperatures of the first and second materials 13, 14, respectively, to facilitate deposition of the first and second materials on the substrate 100.

In certain applications, in order to avoid contamination of the two sublimated gases, the carrier gas may first carry the sublimated gas of the material that sublimes at a lower temperature. The carrier gas then carries the sublimated gas of the material that sublimes at a higher temperature. For example, the carrier gas first carries the sublimated gas of the second material and then carries the sublimated gas of the first material if the second material sublimes at a lower temperature than the first material.

In the illustrated example, two susceptors are provided. In other examples, more than two susceptors may be employed to accommodate the respective first and second materials. Thus, for example, in operation, the carrier gas may pass by all of the susceptors accommodating the second materials, and then pass by all of the susceptors accommodating the first material. Additionally, the system 10 may or may not comprise one or more lids 15 disposed on respective ones of the one or two susceptors 11.

FIG. 10 is a schematic diagram of illustrating a configuration of the system 10 with two inlets 31. The arrangement in FIG. 10 is similar to the arrangement shown in FIG. 9. The two arrangements differ in that the system 10 illustrated in FIG. 10 comprises two inlets 32, and an outlet 33 is disposed between the two susceptors 11.

For the configuration shown in FIG. 10, in operation, first and second carrier gases 54, 55 pass into the sublimation zone 31 from the inlets 32 to carry the respective sublimated gases of the first and second materials. Then, the sublimated gases are mixed in a mixing zone 39 defined between the two susceptors 11 and pass out of the sublimation zone 31 for deposition on the moving substrate 100.

Similarly, more than two susceptors may be employed, and one or more lids may be provided on respective ones of the susceptors 11. The first and second carrier gases 54, 55 may be the same or different gases. Non-limiting examples of the first and second carrier gases include inert gases, such as argon and helium.

For the illustrated example of FIG. 10, the mixing zone and the sublimation zone 31 overlap spatially. The first and second sublimation zones also spatially overlap. In certain examples, the mixing zone may be spatially separated from the sublimation zone 31. The first and second sublimation zones may also be spatially separated from each other.

For the example arrangement illustrated in FIG. 11, a deposition device 30 comprises a first deposition element 40 defining a first sublimation zone 41, a second deposition element 42 defining a second sublimation zone 43, and a mixing element 44 defining a mixing zone 45. First and second passageways 46, 47 provide fluid connections between the mixing zone and the respective first and second sublimation zones 41, 43. A first inlet 48 and a second inlet 49 are disposed on the first and second elements 40, 42 to be in fluid communication with the respective sublimation zones 41, 43, through which first and second carrier gases pass into the sublimation zones 41, 43 to carry the respective sublimated gases.

In the illustrated example of FIG. 11, the first sublimation zone 41, the second sublimation zone 43 and the mixing zone 45 are spatially separated from each other. Accordingly, in operation, the first and second materials are sublimated in the respective sublimation zone 41, 43. Then, first and second carrier gases (not shown) carry the respective sublimated gases into the mixing zone 45 through the respective passageways 48, 49 for mixing. Subsequently, the mixed sublimated gases pass out of the mixing zone from an outlet 33 for deposition on the moving substrate 100.

For the arrangements illustrated in FIGS. 10 and 11, in some applications, the substrate 100 may be stationary. During the sublimation process, the first and second carrier gases may also be saturated with the sublimated gases of the first and second materials 13, 14 to facilitate subsequent deposition on the substrate 100.

Additionally, for some examples, more than two deposition elements and/or more than two susceptors may be employed. One or more lids may or may not be employed on respective ones of the susceptors to adjust the pressures of the one or more sublimated gases. In other applications, the vapor pressure of the one or more sublimated gases in the mixing zone 45 may be adjusted by changing the gas flow resistivity of one or more of the passageways 48, 49.

Various aspects and embodiments of the present disclosure are defined by the following numbered clauses:
1. A system for depositing two or more materials on a substrate, the system comprising:
   one or more susceptors configured to define two or more recesses for accommodating at least a first material and a second material different from the first material respectively; and
   one or more heaters for heating the first material and the second material to sublime for deposition on the substrate.
2. The system of clause 1, wherein each of the one or more susceptors defines the two or more recesses.
3. The system of any preceding clause, wherein the first material and the second material are disposed any preceding in the respective recesses alternately.
4. The system of any preceding clause, wherein the first material and the second material are heated separately to different temperatures.
5. The system of any preceding clause, wherein the first material comprises cadmium telluride, and wherein the first and second materials are deposited on the substrate to form a solar cell.
6. The system of any preceding clause, further comprising one or more lids moveably disposed on respective ones of the recesses and configured to adjust vapor pressure of one or more of the first and second evaporated materials.
7. The system of any preceding clause, further comprising thermal insulation for insulating adjacent ones of the recesses from one another.
8. The system of any preceding clause, wherein each of the one or more heaters comprise a resistive heater, and wherein the resistive heater comprises a coil disposed around one or more of the recesses, and wherein the system further comprises a power source configured to pass an electrical current through the coil to heat one or more of the first and second materials.
9. The system of any preceding clause, wherein the coil disposed around the recess accommodating the first material has more turns than the coil disposed around the recess accommodating the second material.
10. The system of any preceding clause, further comprising a deposition device defining a sublimation zone for accommodating the one or more susceptors.
11. The system of any preceding clause, wherein the substrate is disposed below the one or more susceptors.
12. The system of any preceding clause, further comprising one or more thermal absorption materials disposed around one or more of the recesses to absorb thermal energy from the one or more heaters.
13. A system for depositing two or more materials on a substrate, the system comprising:
   a deposition device defining a sublimation zone, one or more inlets and one or more outlets in fluid communication with the sublimation zone;
   one or more susceptors disposed within the sublimation zone and defining two or more recesses for accommodating at least a first material and a second material different from the first material respectively;
   one or more heaters for heating the first material and the second material for sublimation of the first and second materials; and
   one or more carrier gas sources configured to supply one or more carrier gases into the sublimation zone through the one or more inlets to carry sublimated gases of the first and second materials out of the sublimation zone through the one or more outlets for deposition on the substrate.
14. The system of any preceding clause, wherein the deposition device further comprises a mixing zone configured to mix the sublimated gases prior to deposition of the sublimated gases on the substrate.
15. The system of any preceding clause, wherein the sublimation zone comprises a first sublimation zone and a second sublimation zone configured to accommodate the first and second materials, respectively.
16. The system of any preceding clause, wherein the mixing zone is disposed between the first and second sublimation zones, and wherein the mixing zone spatially overlaps with the first and second sublimation zones.
17. The system of any preceding clause, wherein the first material comprises cadmium telluride, and wherein the first and second materials are deposited on the substrate to form a solar cell.
18. A method for depositing two or more materials on a substrate, the method comprising:
   providing one or more susceptors configured to define two or more recesses for accommodating a first material and a second material different from the first material respectively; and
   heating the first material and the second material for sublimation of the first material and the second material for deposition on the substrate.
19. The method of any preceding clause, further comprising alternately disposing the first material and the second material on the respective recesses.
20. The method of any preceding clause, wherein each of the one or more susceptors defines the two or more recesses.
21. The method of any preceding clause, wherein the first material and the second material are heated separately to different temperatures.
22. The method of any preceding clause, wherein the sublimation is performed by resistive heating the first and second materials by disposing at least one coil around one or more of the recesses and energizing the coil.
23. The method of any preceding clause, further comprising thermally insulating adjacent ones of the recesses from one another.
24. The method of any preceding clause, further comprising providing a deposition device defining a sublimation zone configured to accommodate the one or more susceptors and further defining a mixing zone configured to mix sublimated gases of the first and second materials prior to deposition of the sublimated gases on the substrate.
25. The method of any preceding clause, wherein the deposition device further comprises one or more inlets and one or more outlets in fluid communication with the sublimation zone, the method further comprising supplying one or more carrier gases into the sublimation zone through the one or more inlets to carry the sublimated gases of the first and second materials out of the sublimation zone through the one or more outlets for deposition of the sublimated gases on the substrate.

## Claims

1. A system (10) for depositing two or more materials on a substrate (100), the system (10) comprising:
one or more susceptors (11) configured to define two or more recesses (12) for accommodating at least a first material (13) and a second material (14) different from the first material (13) respectively; and
one or more heaters for heating the first material (13) and the second material (14) to sublime for deposition on the substrate (100); **characterised in that**:
each of the one or more heaters comprise a resistive heater (21), wherein the resistive heater (21) comprises a coil (23) disposed around one or more of the recesses (12), wherein the system (10) further comprises a power source (22) configured to pass an electrical current through the coil (23) to heat one or more of the first and second materials (13, 14), and wherein the coil (23) disposed around the recess (12) accommodating the first material (13) has more turns than the coil (23) disposed around the recess (12) accommodating the second material (14).

2. The system of claim 1, wherein each of the one or more susceptors (11) defines the two or more recesses (12).

3. The system of any preceding claim, wherein the first material (13) and the second material (14) are heated separately to different temperatures.

4. The system of any preceding claim, further comprising one or more lids (15) moveably disposed on respective ones of the recesses (12) and configured to adjust vapor pressure of one or more of the first and second evaporated materials.

5. A method for depositing two or more materials on a substrate (100) using the system (10) of any preceding claim, the method comprising:
providing one or more susceptors (11) configured to define two or more recesses (12) for accommodating a first material (13) and a second material (14) different from the first material (13) respectively; and
heating the first material (13) and the second material (14) for sublimation of the first material (13) and the second material (14) for deposition on the substrate (100).

6. The method of claim 5, further comprising alternately disposing the first material (13) and the second material (14) on the respective recesses (12), and wherein each of the one or more susceptors (11) defines the two or more recesses (12).

7. The method of claim 5 or claim 6, wherein the first material (13) and the second material (14) are heated separately to different temperatures.

## Patentansprüche

1. System (10) zum Abscheiden von zwei oder mehr Materialien auf einem Substrat (100), wobei das System (10) Folgendes umfasst:
einen oder mehrere Suszeptoren (11), die dafür konfiguriert sind, zwei oder mehr Ausnehmungen (12) zum Aufnehmen mindestens eines ersten Materials (13) bzw. eines zweiten Materials (14), das sich von dem ersten Material (13) unterscheidet, zu definieren; und
eine oder mehrere Heizvorrichtungen zum Erwärmen des ersten Materials (13) und des zweiten Materials (14) zum Sublimieren für das Abscheiden auf dem Substrat (100); **dadurch gekennzeichnet, dass**:
jede der einen oder mehreren Heizvorrichtungen eine Widerstandsheizvorrichtung (21) umfasst, wobei die Widerstandsheizvorrichtung (21) eine Spule (23) umfasst, die um eine oder mehrere der Ausnehmungen (12) herum angeordnet ist, wobei das System (10) des Weiteren eine Stromquelle (22) umfasst, die dafür konfiguriert ist, einen elektrischen Strom durch die Spule (23) zu leiten, um eines oder mehrere der ersten und zweiten Materialien (13, 14) zu erwärmen, und wobei die Spule (23), die um die Ausnehmung (12) herum angeordnet ist, die das erste Material (13) aufnimmt, mehr Windungen hat als die Spule (23), die um die Ausnehmung (12) herum angeordnet ist, die das zweite Material (14) aufnimmt.

2. System nach Anspruch 1, wobei jeder des einen oder der mehreren Suszeptoren (11) die zwei oder mehr Ausnehmungen (12) definiert.

3. System nach einem der vorangehenden Ansprüche, wobei das erste Material (13) und das zweite Material (14) getrennt voneinander auf verschiedene Temperaturen erwärmt werden.

4. System nach einem der vorangehenden Ansprüche, das des Weiteren einen oder mehrere Deckel (15) umfasst, die beweglich auf jeweiligen der Ausnehmungen (12) angeordnet sind und dafür konfiguriert sind, den Dampfdruck von einem oder mehreren der ersten und zweiten verdampften Materialien zu justieren.

5. Verfahren zum Abscheiden von zwei oder mehr Materialien auf einem Substrat (100) unter Verwendung des Systems (10) nach einem der vorangehenden Ansprüche, wobei das Verfahren Folgendes umfasst:
Bereitstellen eines oder mehrerer Suszeptoren (11), die dafür konfiguriert sind, zwei oder mehr Ausnehmungen (12) zum Aufnehmen eines ersten Materials (13) bzw. eines zweiten Materials (14), das sich von dem ersten Material (13) unterscheidet, zu definieren; und
Erwärmen des ersten Materials (13) und des zweiten Materials (14) zum Sublimieren des ersten Materials (13) und des zweiten Materials (14) für das Abscheiden auf dem Substrat (100).

6. Verfahren nach Anspruch 5, das des Weiteren umfasst, das erste Material (13) und das zweite Material (14) abwechselnd auf den jeweiligen Ausnehmungen (12) abzuscheiden, und wobei jeder des einen oder der mehreren Suszeptoren (11) die zwei oder mehr Ausnehmungen (12) definiert.

7. Verfahren nach Anspruch 5 oder Anspruch 6, wobei das erste Material (13) und das zweite Material (14) getrennt voneinander auf verschiedene Temperaturen erwärmt werden.

## Revendications

1. Système (10) de dépôt de deux matières ou plus sur un substrat (100), le système (10) comprenant :
un ou plusieurs suscepteurs (11) configurés pour définir deux évidements (12) ou plus pour loger au moins une première matière (13) et une seconde matière (14) différente de la première matière (13) respectivement ; et
un ou plusieurs éléments chauffants destinés à chauffer la première matière (13) et la seconde matière (14) pour les sublimer en vue d'un dépôt sur le substrat (100) ; **caractérisé en ce que** :
chacun des un ou plusieurs éléments chauffants comprend un élément chauffant résistif (21), dans lequel l'élément chauffant résistif (21) comprend une bobine (23) disposée autour d'un ou plusieurs des évidements (12), dans lequel le système (10) comprend en outre une source d'alimentation (22) configurée pour faire passer un courant électrique à travers la bobine (23) pour chauffer une ou plusieurs des première et seconde matières (13, 14), et dans lequel la bobine (23) disposée autour de l'évidement (12) logeant la première matière (13) comporte davantage de spires que la bobine (23) disposée autour de l'évidement (12) logeant la seconde matière (14).

2. Système selon la revendication 1, dans lequel chacun des un ou plusieurs suscepteurs (11) définit les deux évidements (12) ou plus.

3. Système selon l'une quelconque des revendications précédentes, dans lequel la première matière (13) et la seconde matière (14) sont chauffées séparément à des températures différentes.

4. Système selon l'une quelconque des revendications précédentes, comprenant en outre un ou plusieurs couvercles (15) disposés de façon mobile sur des évidements respectifs parmi les évidements (12) et configurés pour ajuster la pression de vapeur d'une ou plusieurs des première et seconde matières évaporées.

5. Procédé de dépôt de deux matières ou plus sur un substrat (100) faisant appel au système (10) de l'une quelconque des revendications précédentes, le procédé comprenant :
la fourniture d'un ou plusieurs suscepteurs (11) configurés pour définir deux évidements (12) ou plus pour loger une première matière (13) et une seconde matière (14) différente de la première matière (13) respectivement ; et
le fait de chauffer la première matière (13) et la seconde matière (14) pour une sublimation de la première matière (13) et de la seconde matière (14) en vue d'un dépôt sur le substrat (100).

6. Procédé selon la revendication 5, comprenant en outre le dépôt en alternance de la première matière (13) et de la seconde matière (14) sur les évidements respectifs (12), et dans lequel chacun des un ou plusieurs suscepteurs (11) définit les deux évidements (12) ou plus.

7. Procédé selon la revendication 5 ou la revendication 6, dans lequel la première matière (13) et la seconde matière (14) sont chauffées séparément à des températures différentes.
